Europäisches Patentamt

European Patent Office

Office européen des brevets

(19)

(11) Numéro de publication: **0 086 714**
**A1**

## (12) DEMANDE DE BREVET EUROPEEN

(21) Numéro de dépôt: **83400288.3**

(22) Date de dépôt: **10.02.83**

(51) Int. Cl.³: **H 01 R 23/70**

(30) Priorité: **12.02.82 FR 8202293**

(43) Date de publication de la demande: **24.08.83**
**Bulletin 83/34**

(84) Etats contractants désignés: **BE CH DE FR GB IT LI LU NL SE**

(71) Demandeur: **Bonhomme, François Robert, 6 Parc de Béarn, F-92210 Saint Cloud (FR)**

(72) Inventeur: **Bonhomme, François Robert, 6 Parc de Béarn, F-92210 Saint Cloud (FR)**

(74) Mandataire: **Lemoine, Michel et al, 13 bld des Batignolles, F-75008 Paris (FR)**

(54) **Connecteur pour cartes à circuits imprimés.**

(57) Pour relier à des broches de sortie (21) les pistes conductrices portées par les bords d'une carte à circuits imprimés (14), un connecteur (1, 2) est muni de contacts élastiques (22) qui relient lesdites pistes à des pistes portées par une nappe (17), ces dernières pistes aboutissant aux broches conductrices (21).

EP 0 086 714 A1

1

Connecteur pour cartes à circuits imprimés.
-------------------------------------------------

La présente invention a trait à un connecteur pour cartes à circuits imprimés et notamment pour cartes à circuits imprimés sur les deux faces.

On sait que les connecteurs pour cartes à circuits imprimés comportent généralement un boîtier à l'intérieur duquel est logée une pluralité de contacts alignés au pas des pistes imprimées de contact situées en bordure sur l'une ou les deux faces de la carte à circuits imprimés. Ces contacts individuels sont eux-mêmes généralement reliés à des fils conducteurs par un raccordement permanent, par exemple par enroulement, sertissage, soudage, etc. Afin de disposer de la place voulue et de ne pas trop fragiliser les outils effectuant les raccordements, les queues de contact destinées à être reliées aux fils sont espacées suivant un pas relativement grand, généralement de 2,54 mm. Lorsque les pistes de raccordement que présente la carte à circuits imprimés sont elles-mêmes disposées suivant ce pas, par exemple 2,54 mm, le connecteur peut alors présenter une forme simple avec une pluralité de contacts identiques entre eux. Cependant, de telles cartes à circuits imprimés ont une surface surabondante pour le logement des composants qui, du fait des progrès de la technique, sont de plus en plus miniaturisés.En fonction de cette miniaturisation, on a donc

2

prévu de diminuer le pas entre les pistes de la carte à circuits imprimés, le pas choisi étant généralement de 1,587 mm, voire de 1,27 mm. Pour de telles cartes à pas réduit, il serait alors concevable d'utiliser des connecteurs dont les contacts individuels seraient eux-mêmes disposés à ce pas réduit, mais la distance entre les queues de sortie devient alors trop faible pour permettre d'effectuer les raccordements avec les fils dans de bonnes conditions. C'est pourquoi il paraît préférable d'utiliser des connecteurs avec des contacts individuels au pas des pistes de la carte, par exemple de 1,587 mm ou 1,27 mm, alors que les sorties de contact, par exemple les queues de contact, sont disposées au pas usuel plus important, par exemple de 2,54 mm.

Une solution pourrait consister à utiliser des connecteurs avec des contacts individuels de plusieurs types géométriques différents, ce qui permettrait de disposer de contacts logés, au niveau des pistes de la carte, au pas resserré de celles-ci, mais dont les sorties se trouveraient disposées au pas usuel élargi. Une telle solution serait cependant extrêmement compliquée et nécessiterait la fabrication de pièces de modèles divers. De plus, dans le cas fréquent où les cartes à circuits imprimés possèdent des pistes sur leurs deux faces, la géométrie d'un tel ensemble deviendrait particulièrement complexe.

L'invention a donc pour but de remédier à ces inconvénients et de fournir un nouveau connecteur, pour cartes à circuits imprimés possédant des pistes situées selon un pas de dimension réduite, avec des sorties de raccordement de connecteur disposées à un pas plus important.

Un autre objectif de l'invention est de fournir un tel connecteur dont l'encombrement longitudinal ne soit que légèrement supérieur à l'encombrement longitudinal des pistes de contact présentées par le bord de carte.

3

Un autre objectif de l'invention est de fournir un tel connecteur permettant de répartir les sorties au pas désiré sur un nombre de rangées supérieur au nombre de rangées de la carte à circuits imprimés, à savoir une rangée pour une carte imprimée sur une seule face ou deux rangées pour une carte imprimée sur ses deux faces.

Un autre objectif de l'invention est de fournir un tel connecteur n'utilisant que des contacts individuels d'un seul type géométrique.

Un autre objectif encore de l'invention est de fournir un tel dispositif ne comportant qu'un nombre réduit de pièces de forme simple et de montage facile.

Enfin, un autre objectif encore de l'invention est de fournir un tel connecteur dans lequel les pièces assurant le contact avec la carte à circuits imprimés et la sortie du connecteur puissent être utilisées sans modification pour des connecteurs ayant des pas déterminés variant dans une assez large gamme.

L'invention a pour objet un connecteur pour cartes à circuits imprimés, du type comprenant un boîtier, une pluralité de contacts individuels disposés au pas d'une carte à circuits imprimés ainsi que des sorties individuelles, par exemple des queues de raccordement, pour le raccordement de conducteurs, fils ou câbles, caractérisé en ce qu'il comporte, dans le boîtier, une ou deux rangées de contacts individuels déformables disposés au pas des pistes de la face correspondante de la carte à circuits imprimés, une pluralité de rangées d'éléments de sortie, tels que par exemple des queues de raccordement, à savoir un par contact individuel, disposés à un pas supérieur au pas desdites pistes, suivant un nombre de rangées supérieur au nombre de rangées de contacts individuels, lesdits éléments de sortie émergeant de préférence hors du boîtier, et une nappe imprimée ou circuit souple présentant une pluralité de conducteurs imprimés, associés aux contacts individuels, pour former, au moins sur une extrémité de ladite nappe, une pluralité de pistes conductrices venant individuellement en contact avec lesdits contacts individuels, les autres extrémités desdits conducteurs imprimés venant se disposer suivant les rangées desdits éléments de sortie et au pas de ces derniers.

Ainsi par exemple, dans le cas d'une carte à circuits imprimés à deux faces dont les pistes sont au pas de 1,587 mm ou 1,27 mm, les éléments de sortie sont avantageusement disposés selon au moins trois rangées au pas de 2,54 mm.

Dans le cas préféré où le connecteur, destiné à recevoir une carte à circuits imprimés sur ses deux faces, présente à cet effet deux rangées parallèles de contacts individuels, la nappe imprimée présente sur deux bords, de préférence d'une même face, deux alignements de pistes au pas desdits contacts, les conducteurs imprimés individuels se terminant suivant lesdites rangées au pas élargi des éléments de sortie dans la zone centrale de la carte.

De façon avantageuse, ladite nappe est réalisée en un matériau souple lui permettant d'être pliée soit en L s'il s'agit d'un connecteur à une seule rangée de contacts, soit en U lorsque le connecteur comprend deux rangées de contacts, ce qui permet facilement de disposer les éléments de sortie, tels que par exemple des queues de contact ou des broches, parallèlement entre eux et au plan de la carte à circuits imprimés.

De préférence, le boîtier de connecteur présente une section transversale sensiblement en U recevant la nappe dans sa position repliée en U, ladite nappe étant maintenue par/une au moins pièce qui, remplissant le boîtier, maintient la nappe dans sa position repliée en U, immobilise les éléments de sortie qui traversent le fond du boîtier et reçoit, dans des alvéoles, les contacts individuels convenablement immobilisés dans cette pièce.

Les éléments de sortie tels que les queues ou broches peuvent avantageusement être montés de façon à perforer la nappe en des emplacements alignés le long des rangées d'éléments de sortie, au pas élargi desdits éléments, chaque conducteur imprimé individuel aboutissant en l'un de ces points de perforation, ceci afin de réaliser un contact électrique par perforation d'un type en soi connu.

Comme contacts individuels, on peut avantageusement utiliser des boucles déformables en métal à ressort, fermées ou ouvertes, maintenues perpendiculairement aux plans des pistes de la carte et des pistes de la nappe, de façon que l'introduction de la carte dans le boîtier provoque une compression de la boucle dont deux sommets opposés sont alors mis en contact l'un avec une piste de la carte, l'autre avec la piste correspondante de la nappe.

De façon avantageuse, ces boucles peuvent être associées à un moyen d'immobilisation assurant tant leur maintien dans leur propre plan que leur immobilisation à l'intérieur du logement.

Grâce à un tracé spécial des pistes du circuit souple, il est possible, conformément à l'invention, d'attribuer, aux sorties de raccordement, un pas supérieur à celui des pistes de la carte à circuits imprimés. L'invention permet ainsi de garder, entre chaque paire de sorties de raccordement, un espace suffisant pour établir, avec un outillage classique, la connexion de chaque sortie de raccordement avec un fil conducteur tout en diminuant le pas des pistes de la carte et par conséquent la surface de celle-ci.

Il est à noter que le US-A-3.941.448 décrit des connecteurs agencés pour relier les pistes d'une carte à circuits imprimés à celles d'une ou de deux nappes imprimées souples, les pistes ayant le même pas sur la carte et sur la nappe. Le problème qui est à l'origine de la présente invention n'y est ni décrit ni suggéré.

Si l'invention permet de diminuer la longueur des connecteurs, il est recommandé de diminuer également leur épaisseur. On arrive ainsi à un boîtier moulé en matière plastique dont les parois ont une épaisseur très faible et peuvent être déformées lors de l'introduction de la carte dans le boîtier. En effet, la pression exercée par la carte sur les contacts en forme de boucle est transmise aux parois du boîtier, ce qui peut provoquer un gonflement de ce dernier si ses parois sont de faible épaisseur.

Afin de diminuer le risque de déformation du boîtier, chaque contact individuel est avantageusement constitué d'une boucle ouverte dont une extrémité est fixe par rapport au boîtier alors que son autre extrémité est libre, cette boucle présentant deux zones de contact situées dans des plans perpendiculaires à la direction d'introduction de la carte qui sont décalés l'un par rapport à l'autre, à savoir une première zone de contact relativement proche de l'extrémité fixe de la boucle et destinée aux pistes de la carte et une deuxième zone de contact relativement proche de l'extrémité mobile de la boucle et destinée aux pistes de la nappe imprimée, le décalage des susdits plans étant tel que, lors du mouvement d'introduction de la carte, le plan de la première zone de contact soit rencontré par la carte avant le plan de la deuxième zone de contact.

Ainsi qu'il sera expliqué ci-après, la forme ouverte et dissymétrique ainsi donnée à la boucle de chaque contact individuel a bien pour effet de réduire les risques de déformation du boîtier.

D'autres avantages et caractéristiques de l'invention apparaîtront à la lecture de la description suivante faite à titre d'exemple non limitatif et se référant au dessin annexé dans lequel :

7

La figure 1 représente schématiquement, en perspective éclatée, le boîtier d'un connecteur selon un premier mode de réalisation de l'invention.

La figure 2 représente, en coupe transversale, le connecteur comportant le boîtier de la figure 1.

La figure 3 représente la nappe souple avant pliage.

La figure 4 représente la nappe souple de la figure 3, pliée en U.

La figure 5 représente, par une vue en coupe analogue à celle de la figure 2, un connecteur selon un deuxième mode de réalisation de l'invention.

Les figures 6 et 7 représentent, à plus grande échelle, l'un des contacts individuels du connecteur de la figure 5, respectivement avant et après l'introduction d'une carte à circuits imprimés.

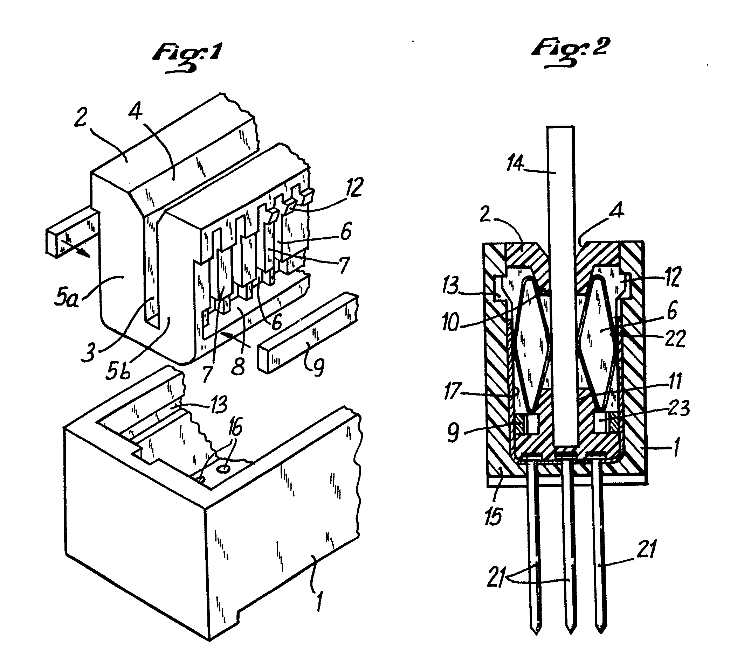

Le connecteur représenté aux figures 1 et 2 comporte un boîtier allongé 1 de forme parallélépipédique, susceptible de recevoir une pièce moulée 2 présentant une forme générale en U avec une fente centrale 3 dont l'ouverture est bordée par un chanfrein 4 pour l'introduction d'une carte à circuits imprimés 14. La pièce 2 est mise en place dans le boîtier 1 qu'elle vient refermer comme on le voit sur la figure 2. Dans chacune des branches 5a et 5b de la section en U, cette pièce 2 comporte une pluralité d'alvéoles traversants 6, s'étendant transversalement à la fente 3 et débouchant d'une part dans la fente 3 et d'autre part sur la face extérieure latérale de la pièce 2. Deux alvéoles successifs 6 sont séparés par des parois transversales 7 dont les parties qui se raccordent à la base 8 de la pièce 2 sont disposées en retrait de la face latérale externe de chaque branche 5a, 5b de façon que l'on puisse loger, en affleurement avec ladite paroi, une barrette longitudinale 9. La forme des alvéoles 6 est bien vue sur la figure 2 et l'on voit que l'épaisseur de chaque paroi 7 séparant deux alvéoles

8

est constante, sauf pour les parties de paroi situées au niveau de la base 8 et destinées à former un logement pour recevoir la barrette 9. Sur la figure 2, on voit en particulier que les alvéoles 6 débouchent dans la fente centrale 3 par une ouverture ayant la largeur de l'alvéole (dans le sens longitudinal du boîtier) mais dont la hauteur est diminuée par rapport à la hauteur de l'alvéole lorsqu'elle débouche à l'extérieur de la branche 5a ou 5b, grâce à la présence de bords inclinés correspondants, l'un supérieur 10, l'autre inférieur 11.

Par ailleurs, les surfaces latérales externes des branches 5a et 5b présentent, sur les parois 7 ou au moins sur certaines d'entre elles, des ergots 12 susceptibles de pénétrer dans des rainures 13 ménagées dans les parois latérales du boîtier 1. Ainsi, grâce à l'élasticité des deux branches 5a et 5b, ces ergots s'effacent lorsque l'on introduit la pièce 2 dans le boîtier 1, et ensuite les ergots 12, en pénétrant dans les rainures 13, empêchent l'extraction de la pièce 2 hors du boîtier 1. Dans cette position de montage, on voit que l'ouverture correspondant à la fente 3 est juste suffisante pour permettre l'enfichage de la carte à circuits imprimés 14.

On notera encore que le fond 15 du boîtier 1 présente trois rangées de trous de sortie 16. Dans chacune des trois rangées ainsi réalisées, les trous 16 sont disposés au pas de 2,54 mm alors que les alvéoles 6 sont au pas de 1,587 mm ou 1,27 mm.

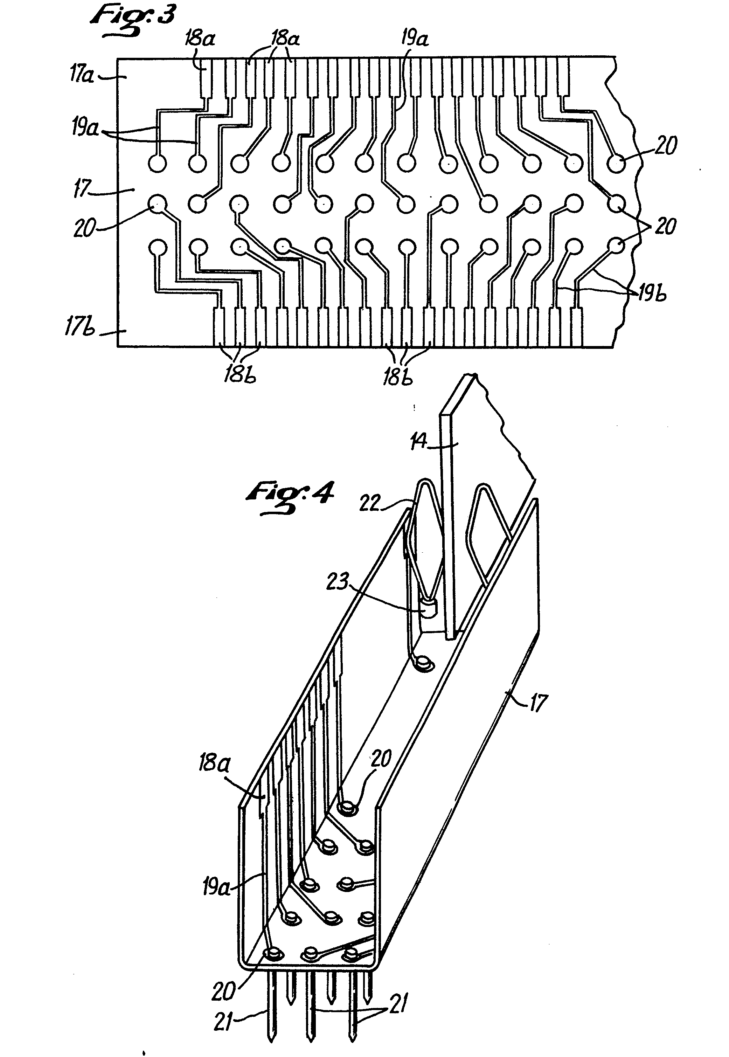

En se référant plus spécialement aux figures 3 et 4, on voit que la nappe 17 du connecteur selon l'invention, formée d'une feuille de matière synthétique souple, par exemple vendue sous la marque MYLAR, possède, sur chacun de ses bords 17a, 17b, une pluralité de pistes conductrices imprimées 18a, 18b, situées en face les unes des autres et au pas réduit de 1,587 mm ou 1,27 mm. Par des conducteurs imprimés 19a, 19b, ces pistes aboutissent respectivement en des plages conductrices imprimées circulaires 20, disposées sur trois ou quatre rangs au pas de 2,54 mm par exemple. Le diamètre de chaque plage imprimée 20 est suffisamment grand pour que, lorsque l'on perfore en son emplacement la nappe 17 par une broche 21, un contact électrique soit établi entre cette broche 21 et l'une des pistes 18a et 18b, par l'intermédiaire de la plage 20 et du conducteur 19a et 19b correspondants. Les plages 20 et les conducteurs 19 sont les restes d'une couche métallique qui recouvrait intialement toute la nappe 17 et qui a été attaquée sélectivement à l'acide. Puis, des avant-trous ont été ménagés avec précision dans la nappe au centre des plages 20, avant le perçage définitif par les broches 21.

Dans l'exemple représenté aux figures 3 et 4, on voit que chaque piste 18a, 18b est adressée uniquement à une seule plage 20 mais il est bien entendu que l'impression pourrait être modifiée de façon quelconque, la liaison des pistes avec les plages 20 pouvant être d'une nature fonctionnelle quelconque. En d'autres termes, une piste telle que 18a ou 18b peut être reliée à plusieurs plages 20 ou une plage 20 à plusieurs pistes.

Dans chaque alvéole 6, on loge un contact individuel 22 (figures 2 et 4) réalisé sous la forme d'une boucle de fil métallique conducteur repliée en losage et dont les extrémités inférieures sont rassemblées dans une base ou cylindre serti 23. La dimension de la petite diagonale du losage constitué par chacun des contacts 22 est déterminée au repos pour que l'un des sommets de petite diagonale vienne s'appliquer contre l'une des pistes 18a ou 18b alors que l'autre vient pénétrer à l'intérieur de la fente 3.

Sur la figure 2, on a représenté la position des contacts individuels 22 dont les bases serties 23 sont reçues dans le fond des alvéoles 6 et maintenues immobilisées en place par les barrettes 9. Dans cette position, les contacts en forme de losange 22 restent maintenus dans la position représentée sur les figures 2 et 4, c'est-à-dire transversalement par rapport au plan longitudinal de la fente 3, sans pouvoir s'écarter notablement de leur plan à cause de la proximité des parois 7 qui séparent les alvéoles 6 entre eux. On voit également que le débattement des contacts 22 vers la fente 3 est limité par la présence des bords 10 et 11 qui limitent les ouvertures des alvéoles 6 vers le centre.

Pour le montage, on met en place tout d'abord les broches ou queues de sortie 21 en perforant la nappe 17 au niveau des avant-trous des plages 20 de façon à amener l'extrémité de chaque broche 21 en contact électrique avec un conducteur imprimé 19a ou 19b, ce qui établit une liaison électrique entre cette broche 21 et la piste correspondante 18a ou 18b, la broche 21 étant ensuite bloquée par soudure, par sertissage ou par un procédé analogue. On met ensuite en place dans le boîtier 1 la nappe 17 avec ses broches 21 de façon que ces broches émergent par les trous 16, comme représenté sur la figure 2. De préférence, on a plié préalablement en U la nappe 17, en la chauffant momentanément en vue de la rendre plus souple et de faciliter ainsi son introduction dans le boîtier 1. Comme on le voit bien sur les figures 2 et 4, la nappe 17 adopte ou conserve ainsi une forme repliée en U avec sa partie centrale qui est appliquée contre le fond 15 du boîtier 1 et deux ailes latérales dont les bords présentent respectivement les pistes 18a et 18b.

Séparément, on monte les contacts individuels 22 dans les alvéoles 6 de la pièce 2 et on immobilise les contacts par la mise en place des barrettes 9. On introduit alors l'ensemble dans le boîtier 1 jusqu'à obtenir la configuration montrée sur la figure 2 dans laquelle la partie centrale de la nappe 17 est maintenue

11

contre le fond 15 du boîtier 1 par l'extrémité inférieure de la pièce 2, ce qui immobilise les broches de raccordement 21. Simultanément, les parties latérales de la nappe 17 se trouvent appliquées contre les faces respectives du boîtier 1, ce qui a pour effet de réaliser un blocage des barrettes 9 et donc l'immobilisation de la base sertie 23 des contacts 22. Les contacts 22 se trouvent eux-mêmes appliqués élastiquement par l'un de leurs petits sommets contre chaque fois une piste 18a ou 18b alors que le sommet diamétralement opposé fait saillie à l'intérieur de la fente 3.

Si on introduit alors une carte 14 dans la fente 3, comme représenté sur la figure 2, les pistes, au pas de 1,587 mm ou 1,27 mm, de la carte 14 viennent au contact des sommets des contacts 22 qui faisaient saillie dans la fente 3 et les repoussent latéralement vers l'extérieur de sorte que les contacts électriques 22 se trouvent appliqués, avec une pression élastique suffisante pour assurer une bonne continuité électrique, à la fois contre les pistes de la carte à circuits imprimés 14 et contre les pistes 18a ou 18b. En conséquence, la continuité électrique est assurée, d'une façon univoque dans l'exemple représenté, entre chaque piste de la carte à circuits imprimés 14 et la broche 21 correspondante.

De cette façon, les broches 21 se présentent sur au moins trois rangées, à un pas nettement supérieur au pas des pistes de la carte à circuits imprimés 14 et des contacts individuels 22. Il est ainsi possible d'utiliser des cartes à circuits imprimés possédant des pistes très rapprochées les unes des autres alors que les queues de raccordement ou broches 21 sont disposées à un pas relativement important qui ne pose aucun problème pour le raccordement à des fils conducteurs, par exemple par sertissage, enroulement ou soudage.

Bien entendu, on conçoit qu'un connecteur similaire pourait être utilisé avec une seule rangée de con-

12

tacts 22 et non pas deux rangées, pour des cartes à circuits imprimés n'ayant des pistes que sur une seule face. Dans ce cas, si l'on prend les pas décrits dans l'exemple, on peut n'avoir que deux rangées de broches 21. Toutefois, on doit noter qu'un connecteur tel que celui représenté sur le dessin peut aussi être utilisé pour les cartes n'ayant des pistes que sur une seule face à condition de laisser inutilisées les broches de raccordement 21 qui correspondent à la rangée de contacts individuels 22 qui n'est pas concernée.

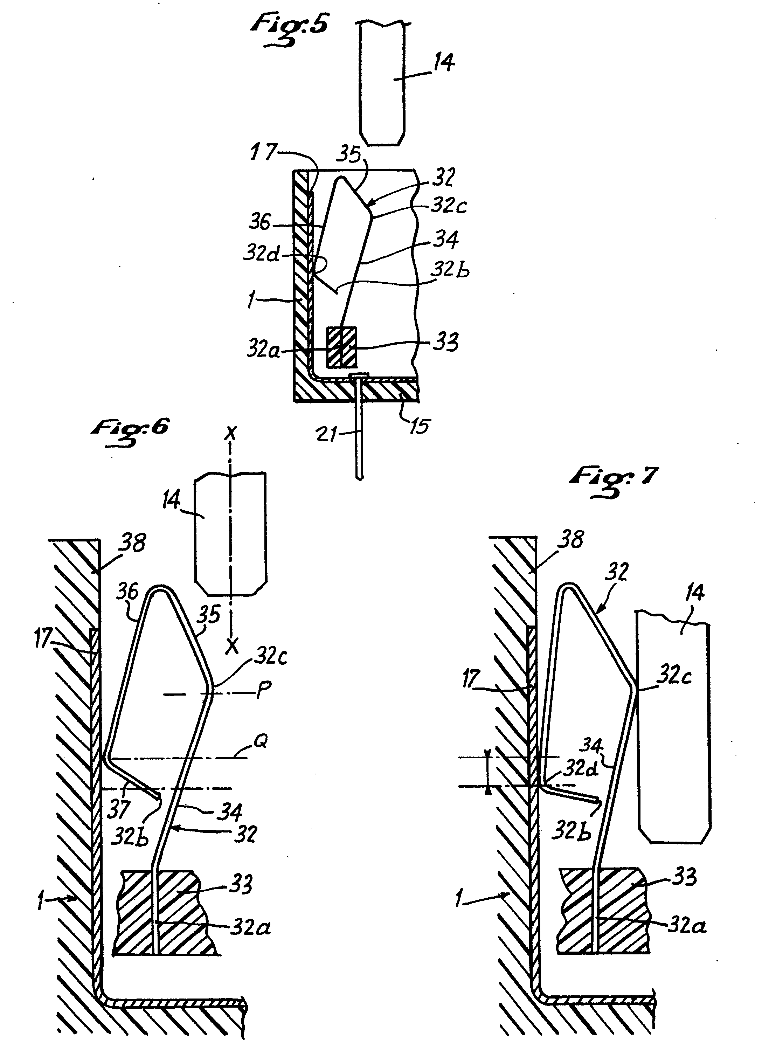

Selon le mode de réalisation des figures 5 à 7, chaque contact 22 formé d'une boucle en forme de losange est remplacé par un contact 32. Ce contact 32 est constitué d'une boucle ouverte dont une extrémité 32a est fixe par rapport au boîtier 1, en étant encastrée dans un porte-contacts 33 solidaire de ce boîtier 1, alors que son autre extrémité 32b est libre. Cette boucle présente deux zones de contact 32c et 32d situées dans des plans P et Q, perpendiculaires à la direction X-X d'introduction de la carte 14, qui sont décalés l'un par rapport à l'autre. La première zone de contact 32c, relativement proche de l'extrémité fixe 32a de la boucle, est destinée aux pistes de la carte 14. La deuxième zone de contact 32d, relativement proche de l'extrémité mobile 32b de la boucle, est destinée aux pistes 18a, 18b (figures 2 et 3) de la nappe imprimée 17. Le décalage mutuel des plans P et Q est tel que le plan P de la première zone de contact 32c soit rencontré par la carte 14, lors de son mouvement d'introduction (de la position de la figure 6 à celle de la figure 7), avant le plan Q de la deuxième zone de contact 32d.

Comme montré à la figure 6, le contact 32 peut comporter, à partir de l'extrémité fixe 32a, quatre côtés approximativement rectilignes, à savoir un premier côté 34 relativement long et se rapprochant, sous une faible inclinaison, de la trajectoire de la carte 14, un deuxième côté 35 plus court et formant un angle obtus avec la premier côté 34 de façon à s'éloigner de ladite trajectoire, un troisième côté 36 sensiblement parallèle au premier côté 34 et un quatrième côté ou bras libre 37 court qui se rapproche du premier côté 34 sans venir le toucher. La première zone de contact 32c est formée à la jonction des premier et deuxième côtés 34 et 35 et la deuxième zone de contact 32d à la jonction des deuxième et troisième côtés 36 et 37.

Lorsque l'on introduit la carte mobile 14 dans le boîtier 1 des connecteurs, celle-ci vient au contact (figure 7) avec la zone 32 qui se déplace vers la paroi 38 du boîtier 1. Ce déplacement provoque une pression en même temps sur la zone 32d du contact 32, c'est-à-dire sur la nappe souple 17, donc sur la paroi 38. Le contact 32 ayant une extrémité libre 32b, il se produit deux actions. D'une part, la pression exercée sur la paroi 38 du boîtier est beaucoup plus faible que si les deux extrémités 32a ou 32b étaient réunies et fixées dans le support 33 et d'autre part, du fait toujours de la liberté de l'extrémité 32b, il se produit un glissement de la zone 32d sur la piste 18a ou 18b de la nappe souple 17, c'est-à-dire un autonettoyage, ainsi qu'il ressort d'une comparaison entre les figures 6 et 7. Cet auto-nettoyage est très important car, lorsqu'une pression de contact est faible et s'il n'y a pas d'effet d'auto-nettoyage, il peut se produire, entre les deux points à raccorder électriquement, une oxydation néfaste à une bonne liaison électrique.

La forme dissymétrique du contact 32 permet, grâce à la zone 32c située vers l'avant du boîtier 1, d'obtenir un bras 34 relativement long et par conséquent, lors de l'introduction de la carte 14, un travail de déformation angulaire qui est faible à la base de ce bras 34. Cette forme dissymétrique permet également de reporter la zone de contact 32d vers l'arrière du boîtier, donc

14

vers la zone moins déformable de la paroi 38 du boîtier 1, et d'éviter ainsi au maximum une déformation de ce boîtier 1.

Bien que l'invention ait été décrite à propos de formes de réalisation particulières, il est bien entendu qu'elle n'y est nullement limitée et qu'on peut lui apporter diverses modifications de forme ou de matériau sans pour cela s'éloigner ni de son cadre, ni de son esprit.

15
REVENDICATIONS

1. Connecteur pour cartes à circuits imprimés du type comprenant un boîtier (1), une pluralité de contacts individuels (22, 32) disposés au pas d'une carte à circuits imprimés (14) ainsi que des sorties individuelles (21) pour le raccordement de conducteurs, fils ou câbles, caractérisé en ce qu'il comporte, dans le boîtier (1), une ou deux rangées de contacts individuels déformables (22, 32) disposés aux pas des pistes de la face correspondante de la carte à circuits imprimés (14), une pluralité de rangées d'éléments de sortie (21), à savoir un par contact individuel (22, 32), disposés à un pas supérieur au pas desdites pistes, suivant un nombre de rangées supérieur au nombre de rangées des contacts individuels (22, 32), et une nappe imprimée souple (17) présentant une pluralité de conducteurs imprimés (19a, 19b) pour former, au moins sur une extrémité de ladite nappe (17), une pluralité de pistes conductrices (18a, 18b) venant individuellement en contact avec lesdits contacts individuels (22, 32), les autres extrémités (20) des conducteurs imprimés (19a, 19b) venant se disposer suivant les rangées des éléments de sortie (21) et au pas de ces derniers pour établir un contact électrique avec eux.

2. Connecteur selon la revendication 1, caractérisé en ce qu'il comporte des contacts individuels (22, 32) disposés au pas de 1,587 mm ou 1,27 mm et des éléments de sortie disposés au pas de 2,54 mm.

3. Connecteur selon l'une des revendications 1 et 2, caractérisé par le fait qu'il comporte deux rangées de contacts individuels (22, 32) et au moins trois rangées d'éléments de sortie (21).

4. Connecteur selon l'une quelconque des revendications 1 à 3, caractérisé en ce que la nappe (17) présente, sur deux bords (17a, 17b) d'une même face, deux alignements de pistes (18a, 18b) au pas desdits contacts (22, 32).

5. Connecteur selon l'une quelconque des revendications 1 à 4, caractérisé en ce que ladite nappe (17) est repliée en L ou en U à l'intérieur d'un boîtier de connecteur (1) et maintenue dans cette position par/une au moins pièce (2) introduite dans le boîtier (1).

6. Connecteur selon l'une quelconque des revendications 1 à 5, caractérisé en ce que les éléments de sortie (21) traversent la nappe (17) par des perforations dans des plages (20) desdits conducteurs imprimés (19$\underline{a}$, 19$\underline{b}$).

7. Connecteur selon l'une quelconque des revendications 1 à 6, caractérisé en ce que le boîtier (1) présente une section approximativement rectangulaire avec des trous (16) dans son fond (15) pour le passage des éléments de sortie (21) et en ce que la nappe (17) est maintenue repliée en U dans le boîtier (1) par une pièce (2) présentant une fente centrale (3) et, dans deux branches (5$\underline{a}$, 5$\underline{b}$) délimitant cette fente (3), une pluralité d'alvéoles traversants (6) recevant lesdits contacts individuels (22, 32) de façon qu'une partie de ceux-ci fasse saillie dans ladite fente (3), des moyens d'encliquetage ou de fixation (12, 13) étant prévus pour maintenir la pièce (2) dans le boîtier (1), la mise en place de ladite pièce (2) assurant le maintien de la nappe (17) dans sa position repliée, la fixation des éléments de sortie (21) dans leur position sur plusieurs rangées et le maintien des contacts individuels (22, 32) dans leurs alvéoles (6).

8. Connecteur selon l'une quelconque des revendications 1 à 7, caractérisé en ce que chaque contact individuel est formé d'une boucle déformable (22, 32) en métal élastique maintenue perpendiculairement aux plans des pistes de la carte (14) et des pistes (18$\underline{a}$, 18$\underline{b}$) de la nappe (17), de façon que l'introduction de la carte (14) dans le boîtier (1) du connecteur provoque une compression de la boucle pour établir un contact

17

élastique simultané d'une part avec la piste correspondante de la carte (14) , d'autre part avec la piste correspondante (18a, 18b) de la nappe (17)

9. Connecteur selon l'ensemble des revendications 7 et 8, caractérisé en ce que chaque contact individuel (22) présente une base (23), notamment une base sertie, maintenue en place dans les alvéoles (6) par des barrettes (9) pénétrant dans ladite pièce (2) et définitivement fixées par l'introduction de cette pièce (2) dans le boîtier (1).

10. Connecteur selon l'une des revendications 8 et 9, caractérisé en ce que chaque contact individuel (32) est constitué d'une boucle ouverte dont une extrémité (32a) est fixe par rapport au boîtier (1) alors que son autre extrémité (32b) est libre et en ce que cette boucle présente deux zones de contact (32c, 32d) situées dans des plans (P, Q) perpendiculaires à la direction d'introduction (X-X) de la carte (14) qui sont décalés l'un par rapport à l'autre, à savoir une première zone de contact (32c) relativement proche de l'extrémité fixe (31a) de la boucle et destinée aux pistes de la carte (14) et une deuxième zone de contact (32d) relativement proche de l'extrémité mobile (32b) de la boucle et destinée aux pistes (18a, 18b) de la nappe imprimée (17), le décalage des susdits plans (P, Q) étant tel que, lors du mouvement d'introduction de la carte (14), le plan (P) de la première zone de contact (32c) soit rencontré par la carte (14) avant le plan (Q) de la deuxième zone de contact (32d).

*Fig.1*

*Fig.2*

2/3

0086714

Fig. 3

Fig. 4

*Fig.5*

*Fig.6*

*Fig.7*

Office européen
des brevets

**RAPPORT DE RECHERCHE EUROPEENNE**

Numéro de la demande

EP 83 40 0288

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | US-A-4 029 374 (G.M.)<br><br>* Figure 3; colonne 3, lignes 42-47; colonne 4, lignes 4-25 * | 1,5,6, 8 | H 01 R 23/70 |
| A | US-A-3 341 806 (SPERRY RAND CORP.)<br>* Figure 1; colonne 1, ligne 70 - colonne 2, ligne 41 * | 1,7,10 | |
| A | FR-A-1 304 823 (BENDIX)<br>* Figure 5; page 2, colonne 1, ligne 8 - colonne 2, ligne 13 * | 1,6,8 | |
| A | GB-A-1 096 938 (AMP)<br>* Figure 1; page 2, lignes 44-78 * | 1 | |
| A | US-A-3 941 448 (DU PONT)<br>* Figures 7,8; colonne 5, lignes 7-47 * | 1 | DOMAINES TECHNIQUES RECHERCHES (Int. Cl. ³)<br><br>H 01 R 9/00<br>H 01 R 23/00 |

Le présent rapport de recherche a été établi pour toutes les revendications

| Lieu de la recherche<br>LA HAYE | Date d'achèvement de la recherche<br>17-05-1983 | Examinateur<br>WAERN G.M. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503. 03.82